# EUROPEAN PATENT APPLICATION

(11) **EP 2 514 856 A2**
(43) Date of publication of application: **24.10.2012**
(21) Application number: 12164359.7
(22) Date of filing: 17.04.2012
(51) Int. Cl.: C25D 7/12, H01L 21/288

(54) **Plating of copper on semiconductors**

(30) Priority: 19.04.2011 US 201161477155 P
(71) Applicant: Rohm and Haas Electronic Materials LLC, Marlborough, MA 01752 (US)
(72) Inventor: Hamm, Gary, Billerica, MA Massachusetts 01821 (US); Reese, Jason A., Londonderry, NH New Hampshire 03053 (US); Wei, Lingyun, Shrewsbury, MA Massachusetts 01545 (US)
(74) Representative: Buckley, Guy Julian

(57) **Abstract**

Monovalent copper plating baths are used to metallize current tracks of the front side or emitter side of semiconductor wafers. Copper is selectively deposited on the current tracks by electrolytic plating or LIP. Additional metallization of the current tracks may be done using conventional metal plating baths. The metalized semiconductors may be used in the manufacture of photovoltaic devices.

## Description

The present invention is directed to a method of plating copper on semiconductors. More specifically, the present invention is directed to a method of plating copper on semiconductors using monovalent copper baths.

Metal plating of doped semiconductors, such as photovoltaics and solar cells, involves the formation of electrically conductive contacts on front and back sides of the semiconductors. The metal coating must be able to establish ohmic contact with the semiconductor in order to ensure that charge carriers emerge from the semiconductor into the electrically conductive contacts without interference. In order to avoid current loss, metallized contact grids must have adequate current conductivities, i.e. a high conductivity or a sufficiently high conductor track cross section.

Numerous processes which meet the above requirements exist for metal coating the back sides of solar cells. For example, in order to improve current conduction at the back side of solar cells, p-doping directly under the back side is reinforced. Usually aluminum is used for this purpose. The aluminum is applied, for example, by vapor deposition or by being printed onto the back side and being driven in or, respectively, alloyed in. When metal coating the front sides, or light incidence sides, the objective is to achieve the least amount of shading of the active semiconductor surface in order to use as much of the surface as possible for capturing photons.

Metal coatings using thick-film techniques are conventional methods for metallizing conductor tracks. Pastes used include metal particles and are electrically conductive as a result. The pastes are applied by screen, mask, pad printing or paste writing. A commonly used process is the screen printing process where finger-shaped metal coating lines having a minimum line width of 80μm to 100μm are made. Even at this grid width electrical conductivity losses are evident in comparison with a pure metal structure. This can have an adverse effect on the series resistance and on the filling factor and efficiency of the solar cell. This effect is intensified at smaller printed-on conductor track widths because the process causes the conductor tracks to become flatter. Nonconductive oxide and glass components between the metal particles constitute a fundamental cause of this reduced conductivity.

More complex processes for producing the front side contacts make use of laser or photographic techniques for the definition of the conductor track structures. The conductor tracks are then metallized. In general, various metal coating steps are often used in order to apply the metal coating in attempting to achieve sufficient adhesive strength and a desired thickness for electrical conductivity. For example, when wet-chemical metal coating processes are used, a first fine metal coating is deposited on the current tracks by means of palladium catalyst. This is often reinforced with electroless deposition of nickel. In order to increase the conductivity, copper may be deposited on the nickel by electroless or electrolytic deposition. The copper may then be coated with a fine layer of tin or silver to protect it from oxidation.

One problem with copper plating of doped semiconductor wafers is that the copper has been found to degrade n-type doped and p-typed doped semiconductor wafers thus shortening their lifetime. A synergistic effect has been discovered between copper contamination and wafer doping. Compared to other metals such as iron the levels of copper required to produce a drastic reduction of the lifetimes are relatively high and relatively acceptable lifetimes are still found for heavily contaminated silicon. For example the lifetime of 1Ωcm p-type silicon is nearly 10μs for a copper concentration of 3x10¹⁴ cm⁻³ which is consistent with a diffusion length of 160μm. Higher copper doses degrade the lifetime even further and a saturation of this trend has not yet been found for a concentration of 3x10¹⁵ cm⁻³. In addition it is important to note that the lifetimes that can be achieved for a particular copper concentration are very different depending on the resistivity of the wafer with lower lifetimes corresponding with lower resistivities. The fact that both the copper dose and the dopant concentration have strong effects on the lifetime is important for future studies of copper in silicon as well as in the development of copper plating baths for photovoltaic manufacture. This problem is described in more detail in the article Journal of The Electrochemical Society, 157 (10) H942-H946 (2010), "Quick Determination of Copper-Metallization Long-Term Impact on Silicon Solar Cells" of J. Bartsch et al.

Another problem with copper plating of doped semiconductor wafers is the undesired deposition of copper on the back side aluminum containing electrodes and silver busbars compromising the performance of the wafers. Such unwanted copper plating occurs when the copper ion in the bath is the cupric or Cu²⁺ ion. The copper plating bath is typically acidic. The copper deposition occurs by an immersion process generated by the dissimilar metals along the back side of the cell without the application of an external current. Also, copper deposited on the back side may migrate into the semiconductor damaging it. In addition such cupric ion containing copper plating baths are not clear but dark in color thus they impede light reaching the semiconductor during light induced plating processes. This may cause non-uniform copper plating resulting in variation of plated copper thickness on current tracks and may compromise the plating rate thus reducing the efficiency of the plating process. Accordingly, there is a need for an improved method of plating copper on semiconductor wafers in the formation of front side current tracks.

A method includes providing a semiconductor including a front side, a back side, and a PN junction, the front side includes a pattern of conductive tracks including an underlayer and the back side includes metal contacts; contacting the semiconductor with a monovalent copper plating composition; and plating copper on the underlayer of the conductive tracks.

The method enables the deposition of copper on the underlayer layer of conductive tracks on the front side of the semiconductor without substantial copper deposition on the metal contacts of the back side. In addition the monovalent copper plating compositions are clear in contrast to the darker blue to green copper plating baths which include cupric ions thus light readily passes through the plating composition to the semiconductor during light induced copper plating. This increases the light intensity on the semiconductor and improves copper deposit uniformity on the underlayer of the current tracks. In general the monovalent copper plating compositions deposit copper at a faster plating rate at comparable current densities than copper plating baths which include cupric ions and at the same time provide comparable copper deposit thickness and current track width. The overall plating efficiency and copper plating performance is improved over copper plating baths which include cupric ions. Further, the method enables the substitution of copper for more costly silver where silver is typically used in coating underlayers of current tracks.

As used throughout this specification, the terms "depositing" and "plating" are used interchangeably. The terms "current tracks" and "conductive tracks" are used interchangeably. The terms "composition" and "bath" are used interchangeably. The indefinite articles "a" and "an" are intended to include both the singular and the plural. The term "selectively depositing" means that metal deposition occurs in specific desired areas on a substrate. The term "cuprous" = Cu⁺ and the term "cupric" = Cu²⁺. The term "lux = Ix" is a unit of illumination equal to one lumen/m²; and one lux = 1.46 milliwatt of radiant electromagnetic (EM) power at a frequency of 540 tetrahertz.

The following abbreviations have the following meanings unless the context clearly indicates otherwise: °C = degrees Celsius; g = grams; mg = milligrams; mL = milliliter; L = liter; A = amperes; dm = decimeter; ASD = A/dm²; cm = centimeter; μm = micrometers; nm = nanometers; LIP = light induced plating or light assisted plating; V = volts; UV = ultra-violet and IR = infrared.

All percentages and ratios are by weight unless otherwise indicated. All ranges are inclusive and combinable in any order except where it is clear that such numerical ranges are constrained to add up to 100%.

Methods include providing a semiconductor including a front side, a back side, and a PN junction, the front side includes a pattern of conductive tracks including an underlayer and the back side includes metal contacts; contacting the semiconductor with a monovalent copper plating composition; and plating copper on the underlayer of the conductive tracks.

Monovalent copper plating compositions may be used to deposit copper on the underlayer of current tracks at various thickness ranges. Such monovalent copper plating compositions may be cyanide free. The monovalent copper compositions may be used to form layers in the current tracks where the copper layer is sandwiched between one or more conductive underlayers and one or more conductive top layers, or may be used to form build up layers to complete the current tracks. Preferably the monovalent copper compositions are used to deposit a thin film layer over the underlayer which is a conductive metal or metal silicide seed layer, barrier layer or combination thereof.

One or more sources of copper ions may be provided in the form of monovalent and divalent copper compounds which are soluble in the plating composition. One or more reducing agents are included in the plating compositions to reduce the cupric ions (Cu²⁺) to cuprous ions (Cu⁺) and maintain cuprous ions in the monovalent state. Copper compounds which may be included in the monovalent copper plating compositions include, but are not limited to, copper fluoborate, cupric oxalate, cuprous chloride, cupric chloride, copper sulfate, copper oxide and copper methane sulfonate. Although cuprous chloride and cupric chloride may be included as a source of cuprous ions, preferred copper compounds are copper oxide, copper sulfate, copper methane sulfonate and other conventional non-halogen water-soluble copper salts. Typically the copper compounds are copper sulfate and copper methane sulfonate. One or more copper compounds may be included in the monovalent copper composition in amounts of 1 g/L to 40 g/L or such as from 5 g/L to 30 g/L.

Reducing agents which may be included in the plating compositions include, but are not limited to, alkali sulfites, alkali bisulfites, hydroxylamines, hydrazines, boranes, sugars, hydantoin and hydantoin derivatives, formaldehyde and formaldehyde analogs. Such reducing agents are included in the plating compositions in amounts of 10 g/L to 150 g/l or such as from 15 g/L to 60 g/L.

Complexing agents may also be included in the monovalent copper plating compositions. Such complexing agents include, but are not limited to, imide and imide derivatives and hydantoin and hydantoin derivatives. Imide derivatives include, but are not limited to, succinimide, 3-methyl-3-ethyl succinimide, 1-3 methyl succinimide, 3-ethyl succinimide, 3,3,4,4-teramethyl succinimide, 3,3,4-trimethyl succinimide and maleimide. Hydantoin derivatives include, but are not limited to, 1-methylhydantoin, 1,3-dimethylhydantoin, 5,5-dimethylhydantoin and allantoin. Amounts of complexing agents are included in the plating composition depend on the amount of copper in the composition. Typically the molar ratio of copper to complexing agent is from 1:1 to 1:5 or such as from 1:2 to 1:4. A typical range of complexing agent concentration is from 4 g/L to 300 g/L or such as from 10 g/L to 100 g/L.

The pH of the monovalent copper plating compositions ranges from 7 to 12, or such as from 7 to 10, or such as from 8 to 9. The pH may be adjusted with any base or alkali salt that is compatible with the plating composition. Such bases include, but are not limited to, sodium hydroxide, potassium hydroxide, ammonium hydroxide and sodium carbonate.

Optionally the plating compositions may include one or more conventional bath additives for copper plating baths such as one or more conductivity salts, and one or more additives to promote uniformity or brightness of the copper deposits. Conductivity salts may be added to improve the conductivity of the plating composition. Any salt that is soluble in and compatible with the plating composition may be used. Such conductivity salts include, but are not limited to, one or more or sulfates, phosphates, citrates, gluconates and tartrates. Examples of such salts are sodium sulfate, potassium pyrophosphate, sodium phosphate, sodium citrate, sodium gluconate and Rochelle salts, such as potassium sodium tartrate. Such salts may be included in amounts of 5 g/L to 75 g/L or such as from 10 g/l to 50 g/L. Preferably chlorides and other halides are excluded from the copper plating compositions.

Additives to improve the brightness and uniformity of the plated copper may be included in the plating compositions. Such additives may include, but are not limited to, organic amine compounds, such as triethylene tetramine and tetraethylene pentamine, and oxyalkyl polyamines, such as polyoxypropyl-triamine. The amount of amine used depends on its activity in the composition, i.e., its ability to brighten the deposit. For example, triethylene tetramine is typically used at a concentration of 0.05 mL/L of plating composition, where polyoxypropyltriamine may be 0.1 g/L. Thus the amount of this additive may range from 0.01 mL/L to 0.5 mL/L.

A typical monovalent copper plating composition may be prepared by first dissolving a complexing agent in water and then adding the source of copper ions in crystalline form or as a slurry. The aqueous solution is then stirred to dissolve the copper compound, the pH is adjusted and one or more reducing agents are added. Other additives are then added to the plating composition. The plating composition may be prepared over a wide temperature range. Typically it is prepared at room temperature. During copper plating the temperature of the monovalent copper plating composition may range from 15° C to 70° C or such as from 40° C to 50° C.

The semiconductors may be composed of monocrystalline or polycrystalline or amorphous silicon. While the description below is with regard to silicon semiconductor wafers, other suitable semiconductor wafers, such as gallium-arsenide, silicon-germanium, and germanium, may also be used. Such semiconductors are typically used in the manufacture of photovoltaic devices and solar cells. When silicon wafers are used, they typically have a p-type base doping.

The semiconductor wafers may be circular, square or rectangular in shape or may be any other suitable shape. Such wafers may have a wide variety of dimensions and surface resistivities. For example, circular wafers may have a diameter of 150 mm, 200 mm, 300 mm, 400 mm, or greater.

The back side of a wafer is metalized to provide a low resistance wafer. Any conventional method may be used. Typically, the surface resistance, also known as sheet resistance, of the semiconductor wafer is 40 to 90 ohms/square, or such as from 40 ohms/square to 60 ohms/square, or such as from 60 ohms/square to 80 ohms/square.

The entire back side may be metal coated or a portion of the back side may be metal coated, such as to form a grid. Busbars are typically included on the back side of the wafer. Such back side metallization may be provided by a variety of techniques. In one embodiment, a metal coating is applied to the back side in the form of an electrically conductive paste, such as a silver-containing paste, an aluminum-containing paste or a silver and aluminum-containing paste; however, other pastes which include metals such as nickel, palladium, copper, zinc or tin also may be used. Such conductive pastes typically include conductive particles embedded in a glass matrix and an organic binder. Conductive pastes may be applied to the wafer by a variety of techniques, such as screen printing. After the paste is applied, it is fired to remove the organic binder. When a conductive paste containing aluminum is used, the aluminum partially diffuses into the back side of the wafer, or if used in a paste also containing silver, may alloy with the silver. Use of such aluminum-containing paste may improve the resistive contact and provide a "p+"-doped region. Heavily doped "p+"-type regions by previous application of aluminum or boron with subsequent interdiffusion may also be produced. In one embodiment, an aluminum-containing paste may be applied to the back side and fired before the application of the back side metal coating. The residue from the fired aluminum-containing paste may optionally be removed prior to the application of the back side metal coating. In an alternate embodiment, a seed layer may be deposited on the back side of the wafer and a metal coating may be deposited on the seed layer by electroless or electrolytic plating.

The front side of the wafer may optionally be subjected to crystal-oriented texture etching in order to impart to the surface an improved light incidence geometry which reduces reflections, such as pyramid formation. To produce the semiconductor junction, phosphorus diffusion or ion implantation takes place on the front side of the wafer to produce an n-doped (n+ or n++) region and provides the wafer with a PN junction. The n-doped region may be referred to as the emitter layer.

An anti-reflective layer is added to the front side or emitter layer of the wafer. In addition the anti-reflective layer may serve as a passivation layer. Suitable anti-reflective layers include, without limitation, silicon oxide layers such as SiOₓ, silicon nitride layers such as Si₃N₄, a combination of silicon oxide and silicon nitride layers, and combinations of a silicon oxide layer, a silicon nitride layer with a titanium oxide layer such as TiOₓ. In the foregoing formulae, x is the number of oxygen atoms. Such anti-reflective layers may be deposited by a number of techniques, such as by various vapor deposition methods, for example, chemical vapor deposition and physical vapor deposition. A chemical edge isolation step may also performed prior to metallization to ensure no current path exists from emitter to back side. Edge isolation may be done using conventional etching solutions well known in the art.

The front side of a wafer is metallized to form a metallized pattern of current tracks and busbars. The current tracks are typically transverse to the busbars and typically have a relatively fine-structure (i.e. dimensions) relative to the busbars.

Current tracks may be formed with metal paste containing silver. The silver paste is selectively applied to the surface of the anti-reflective layer, such as silicon nitride, to a desired thickness depending on the thickness of the final desired current tracks. The amount may vary and such amounts are well known to those of skill in the art. In addition to silver, the paste may include an organic binder and a glass matrix in which electrically conductive particles are embedded. Such pastes are well known in the art and are commercially available. The specific formulations differ depending on the manufacturer, thus the paste formulations are in general proprietary. The paste may be applied by conventional methods used in the formation of current tracks on semiconductors. Such methods include, but are not limited to, screen printing, template printing, dabber printing, paste inscription and rolling on. The pastes possess viscosities suitable for such application methods.

The semiconductor with the paste is placed in a sintering oven to burn through the anti-reflective layer to allow the paste to form a frit or contact between the metal of the paste and the front side or emitter layer of the semiconductor. Conventional sintering methods may be used. Depending on the specific paste composition the sintering may be done in an oxidative atmosphere or under inert gas with minimal oxygen content. A two-stage firing process may also be done with preliminary firing under little oxygen at up to 400° C and subsequent firing at a higher temperature under inert gas or reducing atmosphere. Typically paste firing is done at standard room atmosphere. Such methods are well known in the art.

In an alternative method, the front side or emitter layer of the wafer is coated with an antireflective layer, such as silicon nitride. An opening or pattern is then defined on the front side. The pattern reaches through the antireflective layer to expose the surface of the semiconductor body of the wafer. A variety of processes may be used to form the pattern, such as, but not limited to, laser ablation, mechanical means, and lithographic processes, all of which are well known in the art. Such mechanical means include sawing and scratching. Pattern widths may range from 10μm to 90μm.

The openings may optionally be contacted with acid, such as hydrofluoric acid, or alkali to texture or roughen the surfaces of the exposed emitter layer of the semiconductor. Electrochemical etch processes may also be used to roughen the surfaces of the emitter layer. Various electrochemical etch processes are well known in the art. One such method involves an anodic etch process using solutions of fluorides and bifluorides to form a nanoporous layer on the surface of the emitter layer

In one method an anodic etch process is used to roughen the emitter layer. Conventional oxidizing agents may be used to restore native oxide. Oxidation is typically done with a 1-3wt% aqueous solution of hydrogen peroxide. Other oxidizing agents include, but are not limited to, aqueous solutions of hypochlorite, persulfates, peroxyorganic acids and permanganate. When the semiconductor wafer is monocrystalline, typically the oxidizing solutions are alkaline with a pH greater than 7, or such as from 8-12. When the semiconductor wafer is of silicon, a layer of SiOₓ is formed on the exposed sections. Typically the semiconductor wafer is dipped or processed through a flooded process chamber containing the oxidizing solution. Oxidation may also occur naturally by exposing the semiconductor wafer to the ambient atmosphere.

The emitter layer of the current tracks of the semiconductor wafer is then etched to form a nanoporous layer on the oxidized surface with a composition including one or more sources of bifluorides, one or more fluoride salts or mixtures thereof. Bifluoride source compounds include, but are not limited to, alkali metal bifluorides such as sodium bifluoride and potassium bifluoride, ammonium fluoride, ammonium bifluoride, fluoborates, fluorboric acid, tin bifluoride, antimony bifluoride, tetrabutylammonium tetrafluoroborate, aluminum hexafluoride and quaternary salts of aliphatic amines, aromatic amines and nitrogen-containing heterocyclic compounds. Fluoride salts include, but are not limited to, alkali metal fluorides, such as sodium and potassium fluoride. Typically, bifluoride source compounds and fluoride salts are included in the compositions in amounts of 5 g/L to 100 g/L or such as from 10 g/L to 70 g/L or such as from 20 g/L to 50 g/L.

Acids which may be included in the compositions include, but are not limited to, sulfamic acid, alkane sulfonic acids such as methane sulfonic acid, ethane sulfonic acid and propane sulfonic acid; alkylol sulfonic acids; aryl sulfonic acids such as toluene sulfonic acid, phenyl sulfonic acid and phenol sulfonic acid; amino-containing sulfonic acids such as amido sulfonic acid; mineral acids, such as sulfuric acid, nitric acid and hydrochloric acid; amino acids, carboxylic acids including mono-, di- and tricarboxylic acids, their esters, amides and any unreacted anhydrides. Further, the compositions may contain a mixture of acids. When two or more carboxylic acids are included in the compositions at least one contains an acidic proton to form the bifluoride species. Such acids are generally commercially available from a variety of sources, such as Aldrich Chemical Company. In general, acids and acid anhydrides are included in the electrochemical compositions in amounts of 1 g/L to 300 g/L or such as from 10 g/L to 200 g/L or such as 30 g/L to 100 g/L.

The electrochemical compositions are prepared by combining stoichiometric quantities of one or more acid and one or more bifluoride source compounds or one or more fluoride salts or mixtures thereof. Mixing is done until the bifluoride components or fluoride salts are dissolved in the acid. Water may be added with further mixing to dissolve any un-solubilized components.

Alternatively, one or more acid anhydrides are added to an aqueous solution of at least one bifluoride source to form upon contact with water at least one carboxylic acid. One or more carboxylic acids may be present in the aqueous bifluoride source compound solution provided that enough acid anhydride is stoichiometrically employed to attain a water content of 1-5wt%. This combination is then mixed until the acid anhydride hydrolyzes and the bifluoride source compound dissolves. Additional water may be added with further mixing until all of the components are dissolved.

Typically the electrochemical compositions include one or more alkali metal bifluoride, ammonium fluoride and ammonium bifluoride as the bifluoride source compound. More typically, the bifluoride source compound is an alkali metal bifluoride, such as sodium and potassium bifluoride. When the bifluoride source compound is an alkali metal bifluoride, one or more inorganic acids are included in the electrochemical composition, such as sulfamic acid. When the bifluoride source compound is ammonium bifluoride or ammonium fluoride, one or more carboxylic acids are included in the electrochemical composition. Typically a monocarboxylic acid is included, such as acetic acid.

Optionally a wide variety of surfactants can be used in the electrochemical compositions. Any of anionic, cationic, amphoteric and nonionic surfactants may be used as long as it does not interfere with the performance of the etching. Surfactants may be included in conventional amounts.

Optionally, the electrochemical compositions contain one or more additional components. Such additional components include, without limitation, brighteners, grain refiners and ductility enhancers. Such additional components are well known in the art and are used in conventional amounts.

The electrochemical compositions optionally contain a buffering agent. Buffering agents include, but are not limited to, borate buffer (such as borax), phosphate buffer, citrate buffer, carbonate buffer, and hydroxide buffer. The amount of the buffer used is that amount sufficient to maintain the pH of the electrochemical composition at a desired level of 1 to 6, typically from 1 to 2.

The semiconductor wafer is immersed in the electrochemical composition contained in a chemically inert etching and plating cell. The working temperature of the electrochemical composition may be from 10 to 100 °C, or such as from 20 to 50 °C. A rear side potential (rectifier) is applied to the semiconductor wafer. An inert counter electrode is also immersed in the cell. Typically the counter electrode is a platinum wire or screen electrode. The cell, semiconductor wafer, electrochemical composition and rectifier are in electrical communication with each other.

An anodic potential is generated in the electrochemical composition and at the semiconductor wafer and maintained for a predetermined time followed by turning off current for a predetermined time and the cycle is repeated for a sufficient number of times to provide substantially uniform nanoporous layers on the oxidized emitter layer and at the same time penetrate the surface of the oxidized emitter layer such that the electrical performance of the semiconductor is not compromised. The method is a balance between emitter layer penetration to form a substantially uniform nanoporous emitter layer surface and a sheet resistivity which enables metal deposition resulting in metal layers with good adhesion and ohmic contact with the semiconductor wafer. In addition, the method is a balance between minimizing attack or damage to an antireflective coating on the emitter layer and at the same time forming a nanoporous emitter layer. The oxidized sections of the emitter layer are made nanoporous to a depth such that metal adheres well to the emitter layer and at the same time the resistivity of the emitter layer is conductive enough to plate metal. The deeper the nanoporous layer penetrates into the emitter layer, the greater the sheet resistivity of the emitter layer. In general, the substantially uniform nanoporous layer penetrates deep enough into the emitter layer such that the sheet resistivity of the emitter layer increases from 5% to 40%, or such as from 20% to 30% of the sheet resistivity of the emitter layer prior to initiating application of the anodic potential. Typically, the sheet resistivity of the uniform nanoporous emitter layer is 200 ohms/square and less. Factors such as emitter thickness and doping profile are also parameters to consider in determining emitter layer nanoporous depth and emitter layer resistivity. Minor experimentation may be done to determine the emitter layer nanoporous depth and emitter layer resistivity to achieve metal plating and good metal adhesion for a particular semiconductor wafer.

In general, current density during application of the anodic potential may range from 0.01 A/dm² to 2 A/dm² or such as from 0.05 A/dm² to 1 A/dm². However, minor experimentation may be done to determine preferred current density settings, time period for applying the anodic potential and turning it off for a particular semiconductor wafer. Such parameters depend on the thickness of the semiconductor wafer as well as starting thickness of the emitter layer and desired thickness of the nanoporous emitter layer. If the nanoporous portion of the emitter layer is too deep, the semiconductor may be damaged such that its sheet resistivity is increased. Too high a sheet resistivity compromises the electrical conductivity of the current tracks which are formed on the nanoporous sections of the emitter layer. In addition non-uniform nanoporous layers over the surface of the emitter may result in poor adhesion of subsequently plated metal layers. Typically anodic potential is applied for 0.5 seconds and greater or such as for 0.5 seconds to 2 seconds or such as from 3 seconds to 8 seconds. Time where the anodic potential is discontinued during the cycle may range from 1 second and greater or such as from 3 seconds to 10 seconds or such as 10 seconds to 50 seconds. The number of cycles may range from 5 to 80 or such as from 10 to 100.

Also prior to metal plating the semiconductor may be edge masked. Edge masking reduces the probability of shunting the semiconductor wafer during metallization due to bridging of metal deposits from the n-type emitter layer to the p-type layer of the semiconductor wafer. Edge masking may be done by applying a conventional plating resist along the edge of the semiconductor wafer prior to metallization. Such plating resists may be a wax based composition which includes one or more waxes, such as montan wax, paraffin wax, soy, vegetable waxes and animal waxes. In addition, such resists may include one or more crosslinking agents, such as conventional acrylates, diacrylates and triacrylates, and one or more curing agents to cure the resist upon exposure to radiation, such as UV and visible light. Curing agents include, but are not limited to, conventional photoinitiators used in photoresists and other photosensitive compositions. Such photoinitiators are well known in the art and published in the literature. Such plating resists may be applied by conventional screen printing procedures or by selective ink jet processes. Alternatively, the semiconductor wafer may be edge masked with the antireflective layer. This may be done by depositing the material used to make the antireflective layer on the edges of the semiconductor layer during formation of the antireflective layer.

Irrespective of whether the current tracks are formed by the metal paste method or by one or more of the alternative texturing and roughening methods described above, an underlayer of metal or metal silicide which functions as a seed layer, barrier layer or combination thereof is then deposited onto the fired metal paste or on the textured and roughened emitter layer. Various metals may be used to form the underlayer. Typically the metals are nickel, palladium, silver, cobalt and molybdenum. The various alloys of such metals also may be used. Typically the metals are nickel, palladium or cobalt. More typically the metal is nickel or palladium. Most typically the metal is nickel. Such underlayers may be deposited by using conventional electroless, electrolytic, LIP, sputtering, chemical vapor deposition and physical vapor deposition methods well known in the art. While various metals are envisioned to form the underlayer, methods described below are described using nickel as the metal; however, metals such as palladium, silver and cobalt may be readily substituted in the methods for nickel using conventional electroless and electrolytic metal plating baths.

Typically the nickel is deposited by light induced plating. If the source of the nickel is an electroless nickel composition, plating is done without application of external current. If the source of the nickel is from an electrolytic nickel composition, a rear side potential (rectifier) is applied to the semiconductor wafer substrate. Typical current densities are from 0.1 A/dm² to 2 A/dm², more typically from 0.5 A/dm² to 1.5 A/dm². The light may be continuous or pulsed. Light which may be used to plate includes, but is not limited to, visible light, infrared, UV and X-rays. Light sources include, but are not limited to, incandescent lamps, LED lights (light emitting diodes), infrared lamps, fluorescent lamps, halogen lamps and lasers. Light intensities may range from 400 lx to 20,000 lx, or such as from 500 lx to 7500 lx. Nickel plating is done until an underlayer of 20nm to 1μm thickness, or such as from 50nm to 150nm is deposited; however, the exact thickness depends on various factors such as semiconductor size, current track pattern and geometry of the semiconductor. Minor experimentation may be done to determine the exact nickel layer thickness for a given semiconductor.

In an additional embodiment nickel may be included in the electrochemical composition described above. After the emitter layer is etched to form the porous surface, the current is changed from anodic to cathodic to deposit the underlayer. Current densities for such underlayer formation are the same as disclosed above. Light may be applied to the front of the wafer for light induced plating.

Conventional electroless and electrolytic nickel baths may be used to form the underlayer. Examples of commercially available electroless nickel baths include Duraposit™ SMT 88 and NiPosit™ PM 980 and PM 988. All are available from Rohm and Haas Electronic Materials, LLC, Marlborough, MA, U.S.A. Examples of commercially available electrolytic nickel baths are the Nickel Gleam™ series of electrolytic products obtainable from Rohm and Haas Electronic Materials, LLC. Other examples of suitable electrolytic nickel plating baths are the Watts-type baths disclosed in U.S. 3,041,255.

In an alternative embodiment for the formation of the nickel underlayer, light is applied to the semiconductor at an initial intensity for a predetermined amount of time followed by reducing the initial light intensity to a predetermined amount for the remainder of the plating cycle to deposit nickel onto the current tracks of the doped semiconductor. The light intensity applied to the semiconductor following the initial light intensity and applied for the remainder of the plating cycle is always less than the initial intensity. The absolute values of the initial light intensity and the reduced light intensity following the initial period vary and they may be varied during the plating process to achieve optimum plating results as long as the initial light intensity is higher than the light intensity for the remainder of the plating cycle. If the initial light intensity varies during the initial time period, the light intensity applied for the remainder of the plating cycle may be based on the average of the initial light intensity. Minor experimentation may be performed to determine a suitable initial light intensity, a suitable initial time period for applying the initial light intensity, and a light intensity applied for the remainder of the plating cycle. If the initial light intensity is maintained for too long, poor nickel deposit adhesion and flaking may occur due to a relatively high nickel deposit stress. If the light is extinguished, undesirable nickel plating may occur on the back side of the semiconductor wafer.

In general the initial time period for applying the initial light intensity is greater than 0 seconds to 15 seconds. Typically, the initial light intensity is applied to the semiconductor for 0.25 seconds to 15 seconds, more typically 2 seconds to 15 seconds, most typically for 5 seconds to 10 seconds.

In general, the reduced light intensity is 5% to 50% of the initial light intensity. Typically, the reduced light intensity is from 20% to 50%, or such as from 30% to 40% of the initial light intensity.

In general the amount of light initially applied to the semiconductor may be 8000 lx to 20,000 lx, or such as from 10000 lx to 15,000 lx. In general the amount of light applied to the semiconductor wafer for the remainder of the plating cycle may be from 400 lx to 10,000 lx, or such as from 500 lx to 7500 lx.

In a further embodiment after the nickel is deposited, the wafer is sintered to form a silicide. Typically not all of the nickel deposit reacts with the semiconductor material during sintering. Accordingly, a nickel layer remains on top of the nickel silicide. The nickel silicide is between the nickel layer and adjacent the semiconductor material. Sintering is done in a lamp based furnace (IR) which achieves a wafer peak temperature of 300° C to 600° C. The higher the sintering temperature applied the shorter the sintering cycle or time period in which the semiconductor remains in the oven. If the semiconductor remains too long in the oven at a given temperature, nickel may diffuse too deeply into the wafer penetrating the emitter layer thus shunting the cell. Such sintering processes are well known in the art and some minor experimentation may be required to achieve an optimum sintering cycle. Optionally, after the nickel silicide is formed the unreacted nickel may be stripped from the nickel silicide using an inorganic acid such as nitric acid.

After the underlayer is formed a copper layer is plated on it from the monovalent copper bath. Copper layers may be deposited on the underlayer ranging from 1 μm to 50μm or such as from 5μm to 25μm. Copper plating may be done by electrolytic plating or by LIP. When plating is done by electroplating it is typically front contact plating and LIP is typically done by rear contact plating. Current density during copper plating may range from 0.01 A/dm² to 5 A/dm² or such as from 0.5 A/dm² to 2 A/dm². When LIP is used to plate the copper, light is applied to the front side of the wafer and a rear side potential (rectifier) is applied to the semiconductor wafer substrate. By illuminating the front of the semiconductor wafer with light energy plating occurs on the front. The impinging light energy generates a current in the semiconductor. The light may be continuous or pulsed. Pulsed illumination can be achieved, for example, by interrupting the light with a mechanical chopper or an electronic device may be used to cycle power to the lights intermittently based on a desired cycle. Light which may be used to plate is described above. In general the amount of light applied to the semiconductor wafer during plating may be from 10,000 lx to 70,000 lx, or such as from 30,000 lx to 50,000 lx.

Typically a tin flash layer is then deposited onto the copper to prevent oxidation of the copper layer. Tin flash layers may range from 0.25μm to 2μm. Conventional tin plating baths may be used to deposit the flash layer on the copper. Tin plating may be done by conventional electroless and electrolytic methods including light induced plating. When an electrolytic tin bath is used, current densities may range from 0.1 A/dm² to 3 A/dm². As an alternative to tin a flash layer of tin/lead alloy may be plated. In addition to tin or tin/lead layers of silver or electroless nickel immersion gold may be plated. Also an organic solubility preservative may be applied to the copper or tin or tin/lead flash layer. Such organic solubility preservative layers are well known in the art.

The methods enable the deposition of copper on the pattern of conductive tracks on the front side of the semiconductor without substantial copper deposition on the metal contacts of the back side. Copper on the back side metal contacts typically results in undesirable copper diffusion into the bulk silicon. Copper is essentially a poison to the semiconductor wafer and its use in the manufacture of photovoltaic devices is preferably restricted, yet at the same time is an important metal in the manufacture of photovoltaic devices. In addition the monovalent copper plating compositions are clear in contrast to the darker blue to green copper plating baths which include cupric ions thus light readily passes through the plating composition to the semiconductor during light induced copper plating. This increases the light intensity on the semiconductor and improves copper deposit uniformity on the current tracks. In general the monovalent copper plating compositions deposit copper at a faster plating rate at comparable current densities than copper plating baths which include cupric ions and at the same time provide comparable copper deposit thickness and current track width. The overall plating efficiency and copper plating performance is improved over copper plating baths which include cupric ions. Further, the method enables the substitution of copper for more costly silver where silver is typically used in the formation of current tracks.

The following examples are included to illustrate the invention but are not intended to limit the scope of the invention.

### Examples 1-6

Six monocrystalline semiconductor wafers containing a plurality of silver paste generated current tracks and bus bars on the front side were provided. The rear side of each wafer included an aluminum electrode. The wafers were doped to provide a PN junction. Each wafer was then weighed on an Ohaus EO2140 analytical balance. The weight of each wafer was recorded as shown in Table II below.

Three of the wafers were then immersed into separate chemically inert plating cells containing ENLIGHT™ 420 Electrolytic Copper plating baths (available from Rohm and Haas Electronic Materials, LLC, Marlborough, MA). The baths included copper ions as cupric ions (Cu²⁺) and had a pH of less than 1. The baths were free of copper ion reducing agents. The baths were dark blue in color. The counter electrodes were soluble phosphorized copper anodes. The back side of each wafer and the counter electrodes were connected to three separate conventional rectifiers to provide electrical communication between the baths and wafers and counter electrodes. The temperatures of the baths were maintained at 30° C and light from 250 Watt halogen lamps were applied to the front side of each wafer. 0.34 volts was applied to each bath. The applied current density in one bath was 2 A/dm², the current density in the second bath was 2.3 A/dm² and the current density in the third bath was 2.5 A/dm². LIP was done for 7.5 minutes to deposit a copper layer on the current tracks of each wafer. The wafers were removed from their respective plating cells and rinsed with water then air dried at room temperature. Each wafer was then weighed on the Ohaus EO2140 analytical balance. The weights are in Table II below.

The second group of three wafers was then immersed into separate chemically inert plating cells containing the monovalent copper bath disclosed in Table I below.

**Table I**

| **COMPONENT** | **AMOUNTS** |
|---|---|
| Copper oxide | 10 g/L |
| Sodium metabisulfite | 35 g/L |
| Dimethylhydantoin | 100 g/L |
| Potassium hydroxide | Buffered to pH 7.5-8.5 |

The counter electrodes were soluble phosphorized copper anodes. The back side of each wafer and the counter electrodes were connected to three separate conventional rectifiers to provide electrical communication between the baths and wafers and counter electrodes. The baths were clear in color. The temperatures of the baths were maintained at 30° C and light from 250 Watt halogen lamps were applied to the front side of each wafer. 0.34 volts was applied to each bath. The applied current density in the fourth bath was 2 A/dm², the current density in the fifth bath was 2.3 A/dm² and the current density in the sixth bath was 2.5 A/dm². LIP was done for 7.5 minutes to deposit a copper layer on the current tracks of each wafer. The wafers were removed from their respective plating cells and rinsed with water then air dried at room temperature. Each wafer was then weighed on the Ohaus EO2140 analytical balance. The weights are in Table II below.

**Table II**

| **Example** | **Bath** | **Weight Before (grams)** | **Weight After (grams)** | **Weight Difference (grams)** | **Current Density ASD** | **Plating Rate (mg/minute)** |
|---|---|---|---|---|---|---|
| 1 | Cupric (acid) | 10.6797 | 10.723 | 0.0433 | 2 | 5.77 |
| 2 | Cupric (acid) | 10.9062 | 10.9546 | 0.0484 | 2.3 | 6.45 |
| 3 | Cupric (acid) | 10.5399 | 10.5928 | 0.0529 | 2.5 | 7.05 |
| 4 | Cuprous (alkaline) | 10.8854 | 10.9701 | 0.08747 | 2 | 11.29 |
| 5 | Cuprous (alkaline) | 10.7591 | 10.8573 | 0.0982 | 2.3 | 13.09 |
| 6 | Cuprous (alkaline) | 10.6569 | 10.7632 | 0.1063 | 2.5 | 14.17 |

The average plating rate of copper from the acid cupric bath was determined to be 6.42 mg/min. In contrast, the average plating rate of copper from the alkaline monovalent copper plating bath was 12.85 mg/min. The plating results showed that copper deposition by LIP was faster from the alkaline monovalent plating bath as compared to copper LIP from the acid cupric bath.

### Example 7

A monocrystalline semiconductor wafer containing an aluminum back side with a silver busbar was placed in a plating cell containing ENLIGHT™ 420 Electrolytic Copper plating bath. The bath was an acid cupric ion bath. The temperature of the bath was 30° C. No current was applied and the plating cell was masked to prevent exposure of the cell to any light, including ambient room lighting. After 8 minutes a deposit of copper was observed on the silver bus bar indicating that copper plated onto the bus bar by immersion plating.

A second monocrystalline semiconductor wafer with an aluminum back side and a silver bus bar was placed in the monovalent copper plating bath shown in Table I in Examples 1-6 above. The bath temperature was 30° C. No current was applied and the plating cell was masked to prevent exposure of the cell to any light, including ambient room lighting. After remaining in the bath for 8 minutes there was no observable copper deposit on the silver bus bar or the aluminum coating. The monovalent copper plating bath did not show any observable undesirable immersion copper plating as did the acid cupric bath.

### Example 8

A doped monocrystalline silicon wafer having pyramidal elevations on its front side is provided. The wafer has an n+ doped zone on the front side forming an emitter layer. The wafer has a PN junction below the emitter layer. The front side of the wafer is coated with a passivation or antireflective layer composed of Si₃N₄. The front side also has a pattern for current tracks through the antireflective layer which exposes the surface of the wafer. Each current track traverses the entire length of the wafer. The current tracks join a bus bar at an end of the wafer and at the center of the wafer. The back side is p+ doped and contains an aluminum electrode and a silver bus bar. The wafer is placed on a metal plating rack with the back side aluminum electrode and bus bar in direct contact with the metal plating rack. The interface between the cell and rack is sealed along the perimeter of the wafer to minimize solution penetration between the back side of the cell and plating rack. The current tracks and busbar are then oxidized with a 5wt% aqueous hydrogen peroxide solution to ensure that the silicon surface is oxidized.

The wafer is then immersed into an aqueous solution in a plating cell which includes 15 g/L of sodium bifluoride and 30 g/L of sulfamic acid. The rack with wafer is connected to a rectifier and a platinum wire is used as a counter electrode. The aqueous solution, wafers and platinum wire are in electrical communication with each other. The composition is mildly agitated and kept at room temperature. Anodic current of 0.1 A/dm² at 1.2V is initially applied at the wafer for two seconds and then the current is turned off for 1 second. The anodic to 0 current pulsing is repeated for 30 cycles. After the current tracks and bus bars on the front side of the wafer are etched to form a substantially uniform nanoporous emitter layer, the cell is removed from the aqueous solution and rinsed with deionized water.

The doped mononcrystalline silicon wafer is then immersed into a plating cell containing NIKAL™ Electrolytic Nickel plating chemistry. The rack with the wafer is connected to a rectifier and a solid nickel anode functions as the counter electrode in the bath. The wafer functions as the cathode. The bath, wafer and counter electrode are all in electrical communication and a cathodic current of 1 A/dm² is applied for 1 minute. Artificial light is applied to the wafer throughout the plating cycle. The light source is a 250 watt halogen lamp. Plating temperatures range from 30° C to 50° C. Plating continues until a nickel seed layer of 300nm is deposited in the current tracks and busbar.

The nickel plated wafer is then placed in a monovalent copper plating bath having the formulation in the table below.

**Table III**

| **COMPONENT** | **AMOUNT** |
|---|---|
| 5,5' dimethyl hydantoin | 75 g/L |
| Copper sulfate pentahydrate | 27 g/L |
| Sodium sulfite | 30 g/L |
| Triethylene tetamine | 0.05 mL/L |

The pH of the bath is adjusted to 8 with sodium hydroxide. The temperature of the bath is maintained at 45° C. The bath is agitated using a magnetic stirrer.

The rack with wafer is connected to a rectifier and a phosphorized copper soluble anode functions as the counter electrode in the bath. The bath, wafer and counter electrode are all in electrical communication and a cathodic current of 2 A/dm² is applied for 10 minutes to deposit a 10 μm layer of copper on the nickel seed layer of each current track and busbar. Artificial light is applied to the wafer during plating. The light source is a 250 watt halogen lamp. No copper plating is expected on the back side silver bus bar.

## Claims

1. A method comprising:
a) providing a semiconductor comprising a front side, a back side, and a PN junction, the front side comprises a pattern of conductive tracks comprising an underlayer and the back side includes metal contacts;
b) contacting the semiconductor with a monovalent copper plating composition; and
c) plating a copper layer on the underlayer of the conductive tracks.

2. The method of claim 1, wherein the copper is plated by electrolytic plating or light induced plating.

3. The method of claim 1, wherein the underlayer comprises a metal chosen from nickel, cobalt, palladium, silver or molybdenum.

4. The method of claim 1, wherein the underlayer is a metal silicide.

5. The method of claim 1, wherein the monovalent copper plating composition comprises one or more reducing agents.

6. The method of claim 1, wherein the monovalent copper plating composition comprises one or more sources of copper ions chosen from of copper oxide, copper sulfate and copper methane sulfonate.

7. The method of claim 1, wherein the copper layer is 1μm to 50μm thick.

8. The method of claim 1, further comprising depositing a metal flash layer or organic solderability preservative on the copper layer.

9. The method of claim 1, wherein a pH of the monovalent copper plating composition is 7-12.
